(19) Europäisches Patentamt
European Patent Office
Office européen des brevets

(11) **EP 0 965 995 B1**

(12) **EUROPÄISCHE PATENTSCHRIFT**

(45) Veröffentlichungstag und Bekanntmachung des Hinweises auf die Patenterteilung:
**16.02.2005 Patentblatt 2005/07**

(51) Int Cl.⁷: **G11C 29/00**

(21) Anmeldenummer: **99104498.3**

(22) Anmeldetag: **05.03.1999**

(54) **Schaltungsanordnung und Verfahren zur automatischen Erkennung und Beseitigung von Wortleitungs-Bitleitungs-Kurzschlüssen**

Circuit and method for automatic detection and correction of short circuits between wordlines and bitlines

Circuit et procédé de detection et correction automatique de court-circuits des lignes de bit et lignes de mot

(84) Benannte Vertragsstaaten:
**DE FR GB IE IT NL**

(30) Priorität: **26.03.1998 DE 19813504**

(43) Veröffentlichungstag der Anmeldung:
**22.12.1999 Patentblatt 1999/51**

(73) Patentinhaber: **Infineon Technologies AG**
**81669 München (DE)**

(72) Erfinder:
• **Graetz, Thoralf**
**80799 München (DE)**
• **Härle, Dieter**
**81541 München (DE)**
• **Heyne, Patrick**
**81541 München (DE)**

(74) Vertreter: **Müller - Hoffmann & Partner Patentanwälte,**
**Innere Wiener Strasse 17**
**81667 München (DE)**

(56) Entgegenhaltungen:
EP-A- 0 747 824      US-A- 4 485 459
US-A- 4 685 086      US-A- 4 701 695
US-A- 5 134 584

**Beschreibung**

Die vorliegende Erfindung betrifft eine Schaltungsanordnung und ein Verfahren zur automatischen Erkennung und Beseitigung von Wortleitungs-Bitleitungs-Kurzschlüssen einer Sensorverstärker enthaltenden sowie Bitleitungen und redundante Bitleitungen aufweisenden Speicherzellenanordnung, wobei die Sensorverstärker die Speicherzellenanordnung in Speicherblöke teilen.

Wortleitungs-Bitleitungs-Kurzschlüsse verhindern bekanntlich ein Einlesen in und Auslesen aus einer Speicherzellenanordnung eines Speichers. Die Erkennung und Beseitigung von solchen Wortleitungs-Bitleitungs-Kurzschlüssen ist also von großer Bedeutung, um den Betrieb des Speichers gewährleisten zu können.

Solche Wortleitungs-Bitleitungs-Kurzschlüsse treten auf, wenn Wortleitungen und Bitleitungen infolge Fehler oder Unregelmäßigkeiten beim Herstellungsprozeß des Speichers einander berühren oder beispielsweise durch leitende Schmutzteilchen niederohmig verbunden sind.

Ein Verfahren und eine Schaltungsanordnung zur Behebung von Fehlern gemäß Oberbegriff der unabhänigen Ansprüche 1 und 2 ist aus der Druckschrift EP0747824 bekannt.

Bei Speichern, die geteilte Sensorverstärker in den Bitleitungen verwenden, so daß jedem Sensorverstärker zwei Zweige einer Bitleitung oder zwei verschiedene Bitleitungen zugeordnet sind und die Speicherzellen der Speicherzellenanordnung insgesamt in zwei benachbarte Speicherblöcke unterteilt sind, ist zusätzlich zu beachten, daß selbst nach der Ersetzung einer mit einer Wortleitung kurzgeschlossenen Bitleitung in einem Speicherblock der korrekte Betrieb dieser Bitleitung in dem anderen Speicherblock gestört ist: die korrekte Vorladung der Bitleitung des anderen Speicherblocks wird nämlich durch den Kurzschluß zwischen der entsprechenden Bitleitung und einer Wortleitung in dem einen Speicherblock verhindert, so daß ein korrektes Auslesen der entsprechenden Speicherzellen der in dem einen Speicherblock kurzgeschlossenen Bitleitung in dem anderen Speicherblock nicht mehr möglich ist.

Um diese Schwierigkeit zu überwinden, wurde daher bisher nicht nur der defekte Zweig der Bitleitung in dem einen Speicherblock, sondern zusätzlich auch der an sich nicht defekte Zweig der Bitleitung bzw. eine verschiedene Bitleitung in dem anderen Speicherblock durch eine redundante Bitleitung in beiden Speicherblöcken ersetzt. Dies hat den Nachteil zur Folge, daß zur Redundanz praktisch doppelt so viele Bitleitungen bereitgehalten werden müssen, als wenn nur die tatsächlich defekten Bitleitungen bzw. deren Zweige in den jeweiligen Speicherblöcken ersetzt werden müssen. Mit anderen Worten, die Redundanz der bestehenden Speicherzellenanordnungen ist also - was das Auftreten von Wortleitungs-Bitleitungs-Kurzschlüssen anbetrifft - um einen Faktor 2 bei der Verwendung von geteilten Sensorverstärkern vermindert, wenn die tatsächlich durch Kurzschlüsse gestörten Bitleitungen in den beiden Speicherblöcken betrachtet werden.

Es ist daher Aufgabe der vorliegenden Erfindung, eine Schaltungsanordnung und ein Verfahren zur automatischen Erkennung und Beseitigung von Wortleitungs-Bitleitungs-Kurzschlüssen zu schaffen, mit denen eine Steigerung der Redundanz bei Auftreten von solchen Fehlern möglich ist, um so eine verbesserte Ausbeute zu erreichen.

Diese Aufgabe wird durch eine Schaltungsanordnung bzw. ein Verfahren nach Patentanspruche 1 bzw. 2 gelöst.

Bei der Erfindung ist also in den Bitleitungen vor den Sensorverstärkern in jedem Speicherblock jeweils eine Fuse vorgesehen, die in einem Testmodus aktiviert wird, so daß die betreffende kurzgeschlossene Bitleitung in dem entsprechenden Speicherblock von dem Sensorverstärker getrennt wird. Der Zweig der entsprechenden Bitleitung in dem anderen Speicherblock kann so einen korrekten Betrieb ausführen, so daß hier ein Ersatz durch eine redundante Bitleitung nicht erforderlich ist. Dies bedeutet, daß die Flexibilität der Redundanz der Bitleitungen voll erhalten bleibt, da die kurzgeschlossenen Bitleitungen durch den Testmodus durch Aktivieren ihrer Fuses von den Sensorverstärkern abgetrennt werden. Nur diese abgetrennten Bitleitungen brauchen daher in den jeweiligen Speicherblöcken durch redundante Bitleitungen ersetzt zu werden.

Damit ermöglicht die vorliegende Erfindung eine erhebliche und in der Größenordnung eines Faktors 2 liegende Vereinfachung der Redundanz: es müssen lediglich halb so viele redundante Bitleitungen bereitgehalten werden, um durch Wortleitungs-Bitleitungs-Kurzschlüsse gestörte Bitleitungen zu ersetzen. Alternativ ist es auch möglich, die so "eingesparten" redundanten Bitleitungen für die Beseitigung anderer Fehler zu benutzen, was die Ausbeute verbessert.

Das Aktivieren der jeweiligen Fuses in den Bitleitungen während des Testmodus kann auf verschiedene Art und Weise erfolgen: so ist es möglich, zwischen den jeweiligen Fuses und Sensorverstärkern einen Transistor zur Aktivierung der Fuses vorzusehen. Im Testmodus werden dann die Wortleitungen nacheinander aktiviert, und die Bitleitungen werden über das Abschalten von in den Sensorverstärkern vorgesehenen Vorladungs- und Muxingtransistoren voneinander getrennt. Das heißt, die Bitleitungen sind durch die Sensorverstärker getrennt, so daß ein Zweig der gleichen Bitleitung in dem einen Speicherblock von dem anderen Zweig der gleichen Bitleitung in dem anderen Speicherblock getrennt ist. Besteht nun ein Kurzschluß zwischen der aktivierten Wortleitung und einem Bitleitungszweig, so erhält dieser Bitleitungszweig nahezu das gleiche, hohe Potential der Wortleitung. Wird dieser Bitleitungszweig dann über einen zwischen der Fuse dieses Bitleitungszweiges und dem Sensorverstärker gelegenen Transistor auf ein entsprechend niedriges Potential gezogen, so wird die Fuse dieses Bitleitungszweiges aktiviert, und dieser Bitleitungszweig wird vom Sensorverstärker abgetrennt.

Damit stört der kurzgeschlossene Bitleitungszweig nicht mehr den Betrieb des anderen Zweiges der gleichen Bitleitung oder auch eine verschiedene Bitleitung, so daß dieser andere Zweig nicht durch eine redundante Bitleitung ersetzt zu werden braucht. Es ist also ausreichend, wenn lediglich der eine defekte Zweig der Bitleitung in dem einen Speicherblock durch eine redundante Bitleitung ersetzt wird.

Es ist nicht unbedingt erforderlich, den zwischen der Fuse und dem Sensorverstärker liegenden Transistor vorzusehen. Gegebenenfalls ist es nämlich auch möglich, die normale Einschreibstrecke einzusetzen: es wird hierzu im Schreibzyklus eine niedrige (Null-)Spannung an den Sensorverstärker angelegt und/oder gleichzeitig die Wortleitung mit einer hohen Spannung beaufschlagt. Durch die dadurch zu der kurzgeschlossenen Wortleitung aufgetretene Spannungsdifferenz wird die entsprechende Fuse im Testbetrieb durchtrennt.

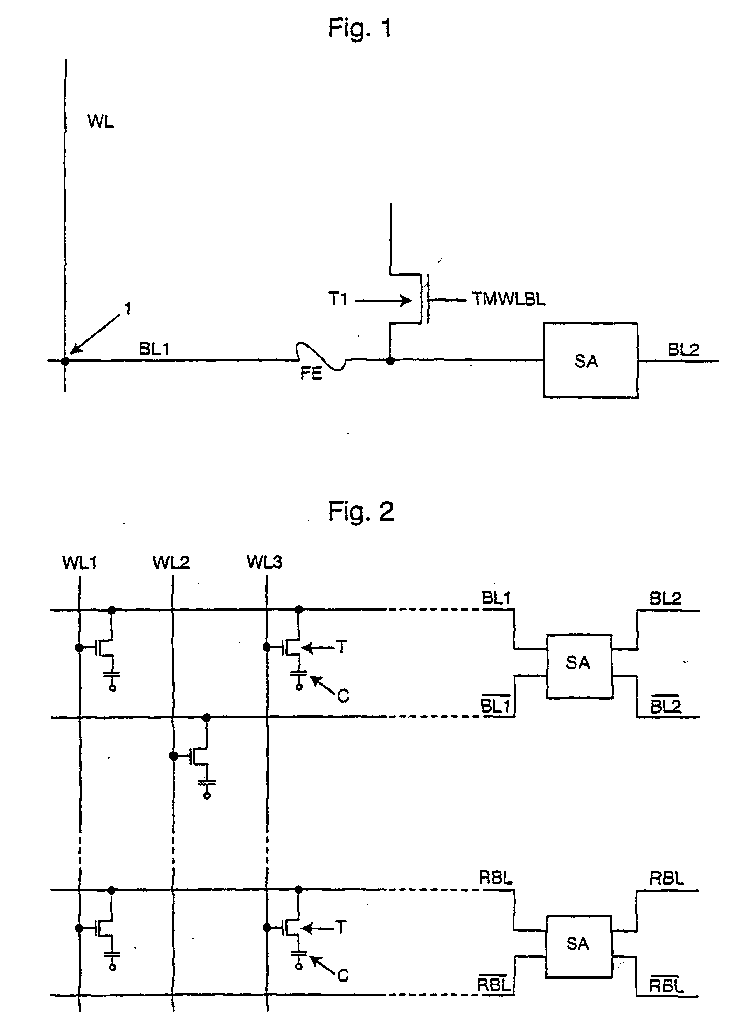

Fig. 2 zeigt eine bestehende Speicherzellenanordnung mit Wortleitungen WL1, WL2, WL3, ..., Bitleitungen BL1, BL2 sowie $\overline{BL}$1, $\overline{BL}$2 und redundanten Bitleitungen RBL, $\overline{RBL}$. Bei den Bitleitungen BL1, BL2 bzw. $\overline{BL}$1, $\overline{BL}$2 kann es sich jeweils um zwei Zweige derselben Bitleitung oder auch um zwei verschiedene Bitleitungen handeln. An Überkreuzungen der Bitleitungen BL1, BL2 sowie $\overline{BL}$1, $\overline{BL}$2 mit den Wortleitungen WL1, WL2, WL3, ... liegen Speicherzellen aus Transistoren T und Kondensatoren C. Aus Architektur- und Platzgründen ist dabei nur jede zweite Überschneidung von Wortleitungen und Bitleitungen mit solchen Speicherzellen belegt. Die den Transistoren T abgewandten Elektroden der Kondensatoren C sind jeweils mit einer konstanten Spannung von beispielsweise 0,9 V beaufschlagt.

Die Bitleitungen BL1, BL2 bzw. $\overline{BL}$1, $\overline{BL}$2 sind, wie in Fig. 2 gezeigt ist, durch einen Sensor- bzw. Leseverstärker SA jeweils in zwei Zweige ("1" bzw. "2") unterteilt. In diesen Sensorverstärkern SA sind (nicht dargestellte) Vorladungs- und Muxingtransistoren enthalten. Die Muxingtransistoren schalten jeweils den "linken" oder "rechten" Zweig einer Bitleitung BL1, BL2 bzw. $\overline{BL}$1, $\overline{BL}$2 ein.

Die Bitleitung $\overline{BL}$1, $\overline{BL}$2 dient als Referenzleitung mit einer Referenzspannung von 0,9 V für den Sensorverstärker SA, wenn die Bitleitung BL1, BL2 gelesen wird. Umgekehrt dient die Bitleitung BL1, BL2 als Referenzleitung für den Sensorverstärker SA mit einer Referenzspannung von 0,9 V, wenn die Bitleitung $\overline{BL}$1, $\overline{BL}$2 gelesen wird.

Die redundanten Bitleitungen RBL, $\overline{RBL}$ sind in gleicher Weise aufgebaut, wie dies oben für die Bitleitungen erläutert ist.

Tritt bei dieser Schaltungsanordnung ein Kurzschluß zwischen beispielsweise der Bitleitung BL1, BL2 und der Wortleitung WL1 ein, so ist nicht nur der Bitleitungszweig (BL1) der Bitleitung BL1, BL2 "links" von dem Sensorverstärker SA, sondern auch der Zweig (BL2) rechts von diesem Sensorverstärker SA gestört, wie dies oben erläutert wurde, so daß die gestörte Bitleitung durch die redundante Bitleitung RBL (bzw. $\overline{RBL}$) ersetzt werden muß.

Die Erfindung schafft hier auf einfache Weise Abhilfe, indem - wie oben erläutert wurde - in den jeweiligen Bitleitungen Fuses vorgesehen werden.

Nachfolgend wird die Erfindung anhand der Zeichnungen näher erläutert. Es zeigen:

Fig. 1    ein Schaltbild mit einer Bitleitung und einer Wortleitung zur Erläuterung der Erfindung, und

Fig. 2    eine bestehende Schaltungsanordnung.

Die Fig. 2 ist bereits eingangs erläutert worden.

In der Fig. 1 werden füreinander entsprechende Teile die gleichen Bezugszeichen wie in Fig. 2 vorgesehen.

Fig. 1 zeigt eine Wortleitung WL, bei der an einem Überschneidungspunkt 1 ein Kurzschluß mit einer Bitleitung BL1, BL2 vorliegt. Die Wortleitung WL entspricht also beispielsweise der Wortleitung WL1 von Fig. 2, während die Bitleitung BL1, BL2 der Bitleitung BL1, BL2 von Fig. 2 zuzuordnen ist. Tritt ein solcher Kurzschluß auf, dann ist nicht nur der Zweig (BL1) der Bitleitung BL1, BL2 auf der "linken" Seite eines Sensorverstärkers SA gestört, sondern auch der Zweig (BL2) der Bitleitung BL1, BL2 auf der "rechten" Seite hiervon. Das heißt, die Bitleitungen beider Speicherblöcke sind gestört. Es sei nochmals angemerkt, daß die Leitungen BL1, BL2 zwei Zweige derselben Bitleitung oder auch zwei verschiedene Bitleitungen sein können.

Um nun zu vermeiden, daß auch der Zweig der Bitleitung BL2 auf der "rechten" Seite des Sensorverstärkers SA durch eine redundante Bitleitung ersetzt werden muß, ist zwischen der Überschneidung 1 und dem Sensorverstärker SA eine Fuse FE vorgesehen, die bei Überschreiten einer bestimmten Grenzspannung "durchbrennt" und die elektrische Verbindung unterbricht. Solche Fuses sind in allen Bitleitungen BL1, BL2 (und $\overline{BL}$1, $\overline{BL}$2) vorgesehen, die zu dem Sensorverstärker SA führen.

In einem Testmodus werden die Wortleitungen WL nacheinander aktiviert und die Bitleitungen BL1, BL2 über das Abschalten der Vorladungs- und Muxingtransistoren in den Sensorverstärkern SA voneinander getrennt. Das heißt, in den Fig. 1 und 2 sind nach Abschalten der Vorladungs- und Muxingtransistoren die "linken" und "rechten" Zweige der Bitleitungen BL1, BL2 jeweils voneinander getrennt. Besteht nun ein Kurzschluß zwischen einer aktivierten Wortleitung WL und einer Bitleitung BL1, so erhält diese Bitleitung BL1 infolge des Kurzschlusses nahezu das hohe Potential der Wortleitung WL. Wird in diesem Zustand die Bitleitung BL1 über einen zwischen der Fuse FE und dem Sensorverstärker SA abgezweigten Transistor T1 auf ein entsprechend niedriges Potential gezogen, wird die Fuse FE aktiviert, so daß der entsprechende Zweig der Bitleitung BL1 von dem Sensorverstärker SA abgetrennt wird. Um dieses Abtrennen zu ermöglichen, wird der Transistor T1 an seinem Gate über ein entsprechendes Signal TMWLBL eingeschaltet, so daß das niedrige Potential über die Source-Drain-Strecke des Transistors T1 zu dem Knotenpunkt zwischen der Fuse FE und dem Sensorverstärker SA gelangt.

Gegebenenfalls kann auf den Transistor T1 auch verzichtet werden. In diesem Fall wird eine niedrige "Spezialspannung" an den Sensorverstärker SA im Schreib-Zyklus gelegt, während eine entsprechend hohe Spannung der Wortleitung WL zugeführt ist. Ist die Spannungsdifferenz zwischen dieser Spezialspannung und der hohen Spannung ausreichend groß, so wird bei einem Kurzschluß zwischen der Wortleitung WL und der Bitleitung BL1 die Fuse FE getrennt.

Die Erfindung ermöglicht also eine Schaltungsanordnung bzw. ein Verfahren, mit der bzw. dem in einem Testmodus nacheinander die Wortleitungen nacheinander aktiviert und die Bitleitungen über das Abschalten der Vorladungs- und Muxingtransistoren voneinander getrennt werden. Bei Vorliegen eines Kurzschlusses zwischen einer aktivierten Wortleitung und einer Bitleitung erhält diese in dem Testmodus nahezu das hohe Potential der Wortleitung. Eine in der Bitleitung vorgesehene Fuse wird in diesem Fall aktiviert, um so die kurzgeschlossene Bitleitung bzw. deren Zweig von dem Sensorverstärker zu trennen.

Dadurch kann die Anzahl der vorzusehenden redundanten Bitleitungen erheblich reduziert werden. Alternativ ist es auch möglich, die so "eingesparten" redundanten Bitleitungen für die Beseitigung anderer Fehler zu benutzen, wodurch insgesamt die Ausbeute gesteigert wird.

**Patentansprüche**

1. Schaltungsanordnung zur automatischen Erkennung und Beseitigung von Wortleitungs-Bitleitungs-Kurzschlüssen einer Sensorverstärker (SA) enthaltenden sowie Bitleitungen (BL1, BL2) und redundante Bitleitungen (RBL) aufweisenden Speicherzellenanordnung, wobei

die Sensorverstärker (SA) die Speicherzellenanordnung in Speicherblöcke so teilt, dass eine Bitleitung (BL1, BL2) durch einen Sensorverstärker (SA) in zwei Zweige geteilt ist, und

- in jedem Zweig der Bitleitungen (BL1, BL2) vor den jeweiligen Sensorverstärkern (SA) eine Fuse (FE) vorgesehen ist,

**dadurch gekennzeichnet, dass**
ein Knotenpunkt zwischen der Fuse (FE) und dem Sensorverstärker (SA) geschaltet ist, an den ein an seinem Gate über ein Signal (TMWBL) einschaltbarer Transistor (T1) zur Zuführung eines niedrigen Potentials gekoppelt ist.

2. Verfahren zur automatischen Erkennung und Beseitigung von Wortleitungs-Bitleitungs-Kurzschlüssen einer Sensorverstärker (SA) enthaltenden sowie Bitleitungen (BL1, BL2) und redundante Bitleitungen (RBL) aufweisenden Speicherzellenanordnung, wobei die Sensorverstärker (SA) die Speicherzellenanordnung in Speicherblöcke so teilen, dass eine Bitleitung (BL1, BL2) durch einen Sensorverstärker (SA) in zwei Zweige geteilt ist,
**dadurch gekennzeichnet, dass** in einem Testmodus Zweige der Bitleitungen (BL1, BL2) mit Kurzschlüssen zu Wortleitungen (WL) durch Aktivieren von Fuses (FE) abgetrennt werden, indem im Kurzschlussfall an der Bitleitung einerseits das hohe Potential der Wortleitung liegt und dieser andererseits mittels eines an seinem Gate über ein Signal (TMWBL) eingeschalteten Transistor (T1) ein niedriges Potential zugeführt ist.

**Claims**

1. Circuit arrangement for automatic recognition and elimination of word line/bit line short circuits in a memory cell arrangement containing sensor amplifiers (SA) and having bit lines (BL1, BL2) and redundant bit lines (RBL), where

- the sensor amplifiers (SA) split the memory cell arrangement into memory blocks such that a bit line (BL1, BL2) is divided into two branches by a sensor amplifier (SA), and
- each branch of the bit lines (BL1, BL2) contains a fuse (FE) upstream of the respective sensor amplifiers (SA),

**characterized in that**
a node is connected between the fuse (FE) and the sensor amplifier (SA), to which a transistor (T1) which can be turned on by means of a signal (TMWBL) on its gate is coupled in order to supply a low potential.

2. Method for automatic recognition and elimination of word line/bit line short circuits in a memory cell arrangement containing sensor amplifiers (SA) and having bit lines (BL1, BL2) and redundant bit lines (RBL), the sensor amplifiers (SA) splitting the memory cell arrangement into memory blocks such that a bit line (BL1, BL2) is divided into two branches by a sensor amplifier (SA),

**characterized in that**

branches of the bit lines (BL1, BL2) which have short circuits to word lines (WL) are isolated in a test mode by activating fuses (FE) by firstly applying the high potential of the word line to the bit line in the event of a short circuit and secondly using a transistor (T1) which can be turned on by means of a signal (TMWBL) on its gate to supply a low potential to the word line.

**Revendications**

1. Circuit de reconnaissance et d'élimination automatique de court-circuits de ligne de mot-ligne de bit d'un dispositif de cellules de mémoire comprenant un amplificateur (SA) de lecture et ayant des lignes (BL1, BL2) de bit et des lignes (RBL) redondantes de bit, dans lequel

   - l'amplificateur (SA) de lecture partage le dispositif de cellules de mémoire en blocs de mémoire de façon à ce qu'une ligne (BL1, BL2) de bit soit divisée par un amplificateur (SA) de lecture en deux branches, et
   - il est prévu, dans chaque branche des lignes (BL1, BL2) de bit avant les amplificateurs (SA) de lecture respectifs, un fusible (FE),

   **caractérisé en ce que**
   il est monté entre le fusible (FE) et l'amplificateur (SA) de lecture, un point nodal auquel est couplé, pour l'application d'un potentiel bas, un transistor (T1) pouvant être mis à l'état passant par sa grille par l'intermédiaire d'un signal (TMWBL).

2. Procédé de détection et d'élimination automatique court-circuits de ligne de mot-ligne de bit d'un dispositif de cellules de mémoire comprenant un amplificateur (SA) de lecture et ayant des lignes (BL1, BL2) de bit et des lignes (RBL) redondantes de bit, dans lequel

   - l'amplificateur (SA) de lecture partage le dispositif de cellules de mémoire en blocs de mémoire de façon à ce qu'une ligne (BL1, BL2) de bit soit divisée par un amplificateur (SA) de lecture en deux branches,

   **caractérisé en ce que** dans un mode de test on sépare des branches des lignes (BL1, BL2) de bit ayant des courts-circuits par rapport à des lignes (WL) de mots, par activation de fusibles (FE), par le fait qu'il s'applique, en cas de court-circuit, à la ligne de bit d'une part le potentiel haut de la ligne de mot et il est appliqué à celle-ci d'autre part un potentiel bas au moyen d'un transistor (T1) rendu passant par sa grille par l'intermédiaire d'un signal (TMWBL).

## Fig. 1

## Fig. 2